Europäisches Patentamt

(19) European Patent Office

Office européen des brevets

(11) Publication number: **0 204 399**
**B1**

(12) **EUROPEAN PATENT SPECIFICATION**

(45) Date of publication of patent specification: **28.02.90**

(21) Application number: **86302335.4**

(22) Date of filing: **27.03.86**

(51) Int. Cl.⁵: **C 23 C 18/22, C 23 C 18/16, C 23 F 1/46**

(54) Method of regenerating permanganate etch bath.

(30) Priority: **31.05.85 US 740129**

(43) Date of publication of application:
**10.12.86 Bulletin 86/50**

(45) Publication of the grant of the patent:
**28.02.90 Bulletin 90/09**

(84) Designated Contracting States:
**AT BE CH DE FR GB IT LI LU NL SE**

(56) References cited:
**WO-A-86/00085**

**PATENTS ABSTRACTS OF JAPAN; & JP - A - 54 003 169 (MATSUSHITA ELEC. IND. K.K.) 01-11-1979**

(73) Proprietor: **MORTON THIOKOL, INC.**
**110 North Wacker Drive**
**Chicago Illinois 60606-1560 (US)**

(72) Inventor: **Krulik, Gerald**
**25142 Barents Street**
**Laguna Hills California 92653 (US)**

(74) Representative: **Bankes, Stephen Charles Digby et al**
**BARON & WARREN 18 South End Kensington London W8 5BU (GB)**

Courier Press, Leamington Spa, England.

## Description

This invention relates to a method for regenerating the spent permanganate ions in a permanganate etch bath by adding a secondary oxidant to the bath.

Hole forming operations in resin containing materials often result in the smearing of resin over the interior wall or barrel of a hole. This resin smear is primarily attributable to the generation or utilization of temperatures exceeding the melting point of a resinous component of the material during the hole forming process.

In many applications, for instance in the manufacture of printed circuit boards, it is essential that the resin smeared on the interior wall of the hole be completely removed. The process of removing these resin deposits is known as "desmearing" and has been accomplished with varying success by a number of techniques. One such technique is to treat the material to be desmeared with a permanganate solution.

Permanganate desmearing solutions and processes are well known. These solutions, for the most part, employ potassium permanganate ($KMnO_4$) and a caustic alkali metal hydroxide. They can vary considerably in both permanganate and caustic concentration.

Examples of such permanganate solutions include those in U.S. Patent No. 1,969,678, issued August 7, 1934 to White et al. which discloses etching solutions for metals, e.g. copper, which contains ferric chloride and an oxidizer which converts ferrous ions to ferric ions. This oxidizer may be $KMnO_4$. Of course, these etching solutions would have at best limited utility in preparing circuit boards since the boards often contain a copper layer which would be subject to removal by the ferric chloride.

U.S. Patent No. 3,293,148, issued December 20, 1966 to Dell et al., discloses a cleaning solution for metals which contains an oxidizer, alkali metal hydroxide, gluconic acid and polyethylene glycol. Among the many oxidizers disclosed are permanganates, although they are not preferred and no example is given employing them.

U.S. Patent No. 3,425,947, issued February 4, 1969 to Rausch et al., relates to solid concentrates useful in preparing treatment baths for removing organic substances from metal surfaces. The concentrates contain about 50—90% alkali metal hydroxide, 10—50% permanganate and 1 gram equivalent/gram mole of permanganate of a reducing agent. Typical solutions prepared by the solid concentrates contain about 105 g/l of $KMnO_4$ and about 250 g/l NaOH.

U.S. Patent No. 3,457,107, issued July 22, 1969 to Mickelson et al., discloses compositions for chemically polishing stainless steel. These compositions are aqueous solutions containing alkali metal hydroxides, e.g. NaOH, and alkali metal permanganate, e.g. $KMnO_4$. Typical solutions contain about 39 g/l NaOH, 16 g/l KMnO g/l and 4.8 g/l $Na_2CO_3$; or 78 g/l NaOH, 32 g/l $KMnO_4$ and 9.6 g/l $Na_2CO_3$.

U.S. Patent No. 3,489,625, issued January 13, 1970 to Dell et al., discloses acid pickling of carbon steel followed by treatment with an alkaline permanganate solution. The alkaline permanganate solution contains about 5—50 g/l $KMnO4$ and about 10—200 g/l alkali metal hydroxide.

U.S. Patent No. 3,506,397, issued April 14, 1970 to Vincent et al., relates to the treatment of ABS resin with a composition containing phosphoric acid and potassium permanganate.

U.S. Patent No. 3,598,630 and 3,647,699, issued respectively on August 10, 1971 and March 7, 1972 to Doty et al., are also related to phosphoric acid/potassium permanganate solutions for treating ABS polymers.

U.S. Patent No. 2,625,758, issued December 7, 1971 to Stahl et al., deals with the manufacture of printed circuit boards. As one step in the manufacturing process, the board is treated with an oxidization and degradating agent which may be a permanganate solution. However, no details or specific examples regarding the composition of the permanganate solution are provided.

U.S. Patent No. 2,652,351, issued March 28, 1972 to Guisti, discloses compositions for etching synthetic polymers. These etchant compositions contain 2.5—8.5% potassium and/or sodium manganate, 30—70% sodium and/or potassium hydroxide and 21.5—67.5% water. These compositions are prepared from the corresponding permanganate which is reacted with a large amount of sodium and/or potassium hydroxide at elevated temperature to reduce the permanganate to manganate. For instance, in Example 1 Guisti combines 50 g KOH, 5 g $KMnO_4$ and 20 g water and heats the resulting mixture at 80—90°C until the deoxidation reaction is complete. Likewise, in Example 2 the reaction mixture contains 45 g NaOH, 6 g $NaMnO_4$ and 20 g water, and Example 3 employs 25 g NaOH, 25 g $KMnO_4$, 3.5 g $NaMnO_4$ and 20 g water.

U.S. Patent No. 3,833,414, issued September 3, 1974 to Grisik et al., discloses a method for removal of aluminide coatings from metal by treating the metal with a mixed acid solution, followed by treatment with an alkaline permanganate aqueous solution, and finally a second treatment with the mixed acid. The alkaline permanganate aqueous solution contains 8—11% NaOH, 8—11% $Na_2CO_3$ and 4—6% $KMnO_4$.

U.S. Patents No. 4,042,729; 4,054,693 and 4,073,740, issued respectively on August 16, 1977; October 18, 1977 and February 14, 1978 to Polichette et al., relate to treating resinous surfaces with a solution of manganate ($MnO_4^{2-}$) and permanganate ($MnO_4^-$) where the molar ratio of manganate/permanganate is up to 1.2 and the pH of the solution is 11—13. Polichette et al. teach that higher pH increases the $MnO_4^{2-}/MnO_4^-$ ratio, which is undesirable.

U.S. Patent No. 4,294,651, issued October 13, 1981 to Ohumra, discloses etching of a semiconductor substrate with a composition containing a fluorine compound (7—38%), an oxidizing

agent such as $KMnO_4$ (2.5—7%) and alkali such as KOH or NaOH (1—10%).

U.S. Patent No. 4,425,380, issued January 10, 1984 to Duffy et al., discloses a process for removing resin smear (desmearing) from an interior wall of a hole in a resinous substrate. The process involves contacting the substrate with an alkaline permanganate solution, having a pH between 11 and 13, at elevated temperature. With regard to the permanganate, it is stated that any metal salt of permanganic acid which is stable and soluble to the extent of at least 10 g/l in water can be employed, sodium permanganate and potassium permanganate being preferred. While it is disclosed that amounts from about 10 g/l up to the limit of solubility of permanganate may be employed, it is emphasized that especially good results are obtained with $NaMnO_4$ or $KMnO_4$ in the range of 10—60 g/l. Further, it is taught that the rate of bonding sites formation increases up to about 60 g/l, but no further increases in rate is noted above this level. Thus, Duffy et al. place a practical upper limit of 60 g/l of permanganate on their desmearing solutions.

U.S. Patent No. 4,430,154, issued February 7, 1984 to Stahl et al., relates to a method for removing an adhesive medium from printed circuit boards without corroding the base material or copper conductor on the board by treatment with an alkaline permanganate or chromic acid solution. The alkaline permanganate solution disclosed contains 50 g/l $KMnO_4$ and 50 g/l NaOH.

British Patent No. 1,479,558 of Kollmorgen Corporation, published on July 13, 1977, also relates to desmearing and etchback of printed circuit boards and wire conductors by treatment with an alkaline permanganate solution containing potassium permanganate, a strong base (e.g. NAOH) and a fluorinated hydrocarbon wetting agent. The solution contains about 10—75 g/l $KMnO_4$ and enough NaOH to achieve a pH of 13—14. Typically, about 40 g/l of NaOH is employed. The desmearing process is conducted at temperatures from about 35—50°C, it being disclosed that temperatures above 70°C result in increased permanganate demand in order to maintain the bath composition without yielding any apparent advantage, i.e. the overall process becomes less efficient in terms of permanganate consumption.

One of the problems encountered with permanganate etch baths involves the conversion of permanganate ion to a manganese species having a lower oxidation state, e.g. manganate, which species have no activity for desmearing or etching. This conversion can occur as a result of the etching or desmearing process or even spontaneously. For example, in the presence of high amounts of caustic, as is often found in permanganate etch baths, permanganate undergoes a disproportionation reaction to manganate. Also, $MnO_2$ precipitates, which can be formed from further disproportionation of manganate and from the oxidation of organic material, catalyze this decomposition of permanganate. The result is that the useful life of the permanganate etch bath is shortened appreciably. In order to maintain a useful etch bath, the permanganate content of the spent of partially spent bath must be replenished (i.e. add new permanganate to the bath) or the bath replaced entirely with a fresh permanganate solution.

It has now been disclosed that a number of sulfur and halide containing strong oxidants can be used to slowly or rapidly regenerate a high caustic permanganate etch bath, thereby obviating the necessity of replenishing or replacing the bath. These materials may be added to the bath continuously or intermittently. These regenerants thus make a high caustic or low caustic, high permanganate bath much more economical to operate. Indeed, in some cases the life of the bath is essentially limitless.

WO—A—86/00085, published on 3rd January 1986 and constituting part of the state of the art within the terms of Articles 53(3) and (4) EPC, discloses the use in an alkaline permanganate composition of a secondary oxidant capable of oxidizing manganate ions to permanganate ions. The preferred secondary oxidant is sodium hypochlorite.

In accordance with the present invention, there is provided a method for regenerating the spent permanganate ions in an alkaline permanganate-containing etchant composition, said method comprising adding to· the composition, in an amount sufficient to oxidize essentially all of the non-permanganate manganese species in the composition to permanganate, an inorganic peroxydisulfate, optionally mixed with an inorganic hypochlorite or an inorganic chlorate.

The process of the present invention relates to a method for regenerating permanganate etchant compositions in which some or all of the permanganate ions have been "spent", i.e. converted to manganese-containing species or ions other than permanganate. As used herein the term "regenerate" refers to the conversion of manganese-containing species or ions other than permanganate to permanganate. The conversion of non-permanganate species to permanganate is accomplished by adding to the composition containing such non-permanganate species an oxidizer compound of this invention in an amount sufficient to convert substantially all of the non-permanganate, manganese-containing species to permanganate.

These inorganic oxidizers can have cations selected from $Na^+$, $K^+$, $Cs^+$, $Rb^+$, $Ca^+$, and the like. However, the choice of cation may be dictated by the particular permanganate etchant composition to be regenerated. For example, for those etchant compositions wherein the primary source of permanganate is $NaMnO_4$ it is generally undesirable to introduce an excess of $K^+$ ions into the composition since the presence of $K^+$ ions will depress the solubility of the $NaMnO_4$. However, the converse is not true for etchant solutions composed primarily of $KMnO_4$. Since the solubility of the $KMnO_4$ is not affected appreciably by the presence of $Na^+$, inorganic oxidizers containing $Na^+$ may be used in $KMnO_4$ etchants. Because $Na^+$ can be used without detriment in both $NaMnO_4$ and $KMnO_4$ solutions, it is the preferred cation for the oxidizers of this invention.

It should be emphasized that not all strong oxidizers were found to be useful for the purpose of this invention. To be effective, useful oxidizers must be capable of oxidizing the non-permanganate, manganese-containing species in the spent bath to permanganate in a medium which is alkaline (often highly alkaline) due to the presence of, e.g., NaOH in the bath. Furthermore, it was discovered that it was not sufficent merely to consult a standard redox table in order to detemine which oxidizers would be useful in this invention. For instance, oxidizers such as peroxides and hydroxylamine would, from the redox table data, be expected to be operative in the present invention. However, they were found to be inoperative. Also, several oxidizers which might be capable of oxidizing manganese-containing species to permanganate were not compatible with the permanganate etch bath or had safety/toxicity problems. On the other hand, the peroxydisulfates used according to the invention, would not have been expected to perform adequately based on the data from standard reference works. Thus, it is believed that their utility in this invention, and especially their superiority over the more obvious oxidizers, is highly unexpected.

The oxidizers used in the present invention are all useful in regenerating permanganate solutions, although they vary in the rate at which they do so.

The peroxydisulfates rapidly convert non-permanganate species, eg. $MnO_4^{2-}$ (manganate) $MnO_2$ (manganese IV dioxide) and $Mn^{2+}$ (manganous ion), to permanganate. They are very efficacious and with them the permanganate etchant bath can be maintained readily. The hypochlorites and chlorates perform better than other types of oxidant such as bromates but are not in themselves as efficient as the peroxydisulfates. The latter is therefore always used but may be combined with hypochlorites or chlorates.

It has been quite unexpectedly discovered that the oxidizers of the present invention not only regenerate permanganate, but do so in the absence of a catalyst. It was believed that the oxidation reaction involved in the regeneration of the permanganate would require a catalyst, e.g. $AgNO_3$, when peroxydisulfates were used. However, these oxidizers were found to regenerate spent baths rapidly without any catalyst present.

The amount of oxidizer added to the spent permanganate bath can vary considerably depending upon several factors. For example, a spent bath which cotains primarily manganese species in a very low oxidation state (e.g. species such as $MnO_2$ or Mn (II) will require a greater amount of oxidizer than a bath which contains manganese species primarily of an intermediate oxidation state (e.g. manganate). Also, the amount of oxidizer required will vary with the particular oxidizer employed, the desired speed of regeneration, bath temperature, permanganate concentration (in the original and/or spent bath), alkalinity of the bath and the like. Thus, quantifying a useful amount of oxidizer for all cases is extremely difficult. In general, however, the amount of oxidizer required is that amount which is sufficient to convert essentially all of the non-permanganate, manganese species in the spent bath to permanganate. In practice, this amount can be quite readily determined by a variety of techniques. For example, the original bath will contain a known amount of permanganate. The spent bath can be analyzed for its remaining permanganate content (as by titration) and the amount of oxidizer required determined therefrom. An even easier method is provided by the inherent color change which the permanganate bath undergoes as it is depleted. Baths containing undepleted permanganate are purple in color, whereas a completely spent bath is green. Thus, when the bath begins to change to a green color (or, if desired, when it has changed to a green color altogether), the oxidizer can be added to the bath until it returns to its original, purple color. If desired, the color change can be monitored via visible spectroscopy, using a few drops of the bath in a concentrated caustic solution. This method is preferred as even small amounts of manganate can be readily seen and sufficient regenerator added to convert it back to permanganate. Yet another way of determining when sufficient oxidizer has been added to the bath to effect full regeneration is to monitor the presence of $MnO_2$ precipitates in the bath. Since these precipitates are more difficult to convert to permanganate than is manganate, when the precipitates disappear any manganate ions in the bath should be converted to permanganate as well, and the bath should be fully regenerated.

It should also be noted that the oxidizer is preferably added to the bath in an amount which is in excess of that required to regenerate the bath. Excess oxidizer in the bath does not adversely affect etch efficiency and allows for some margin of error in the amount of oxidizer used.

The process of this invention may be carried out either continously or as a batch process. In other words, the bath may be maintained in an essentially constantly regenerated state by the periodic addition of oxidizer as the bath is used, or the bath can be allowed to deplete to the point where etch efficiency drops below a useful level and then the oxidizer can be added in a single, large dosage to regenerate the bath. Since the continuous, or periodic method permits the bath to be used without interruption, and allows regeneration even while the bath is actually being used to etch material, it is the preferred embodiment of this invention. This is especially true for those oxidizers of this invention which are relatively slow in regenerating permanganate. By adding the oxidizer continuously or periodically to the bath an excess of oxidizer will always be present in the bath, so the permanganate content is always maintained at a high level. Thus, relatively small amounts of non-permanganate, manganese species need to be oxidized at any given time. Therefore, even though the oxidizer may be a relatively slow regenerator, regeneration time is kept to a minimum.

The present invention will now be further described in the following examples.

Example 1

A spent solution which originally contained about 160 g/l NaMnO$_4$ and 100 g/l NaOH was a pure green color, and was diluted with water to make 250 ml of solution. The solution was then heated to 48.9°C (120°F). Approximately 20 g of Na$_2$S$_2$O$_8$ was added to the hot, green solution with stirring. No catalyst was added. In less than about 2 minutes oxygen was being rapidly evolved from the solution and the solution had turned a pink/purple color, indicating that permanganate had been regenerated in the solution.

Example 2

To a beaker containing 100 ml of the spent solution employed in Example 1 was added 30 g of Na$_2$S$_2$O$_8$ at room temperature. Within about 3 or 4 minutes the solution changed color completely from its original pure green color to purple, indicating that the manganese species in the spent (green) solution had been converted to permanganate (purple). Also, no MnO$_2$ precipitates were found in the bottom of the beaker.

Comparative Example

Sodium bromate was tested as a regenerator for spent permanganate desmearing baths by adding a solution of sodium bromate to a spent (green color) permanganate bath and observing any color change in the bath. No color change was observed, indicating that the sodium bromate solution was not effective in converting any substantial portion of the non-permanganate manganese species to permanganate.

Solid sodium bromate was then added to a bath which contained small amounts of manganate. A color change was observed from green (indicating the presence of the manganate in the bath) to purple indicating the conversion of manganate to permanganate.

This example demonstrates that sodium bromate is effective in oxidizing non-permanganate manganese species to permanganate, but that the rate of oxidation is very slow.

Claims

1. A method for regenerating the spent permanganate ions in an alkaline permanganate-containing etchant composition, said method comprising adding to the composition, in an amount sufficient to oxidize essentially all of the non-permanganate manganese species in the composition to permanganate, an inorganic peroxydisulfate, optionally mixed with an inorganic hypochlorite or an inorganic chlorate.

2. A method according to claim 1 wherein a mixture of an inorganic peroxydisulfate and an inorganic hypochlorite is added.

3. A method according to claim 1 wherein a mixture of an inorganic peroxydulsulfate and an inorganic chlorate is added.

Patentansprüche

1. Verfahren zur Regenerierung der verbrauchten Permanganationen in einer alkalischen permanganathaltigen Ätzzusamensetzung, bei dem man zu der Zusammensetzung ein anorganischen Peroxydisulfat, der gegebenenfalls mit einem anorganischen Hypochlorit oder einem anorganischen Chlorat gemischt ist, in einer ausreichenden Menge, um im wesentlechen alles Nichtpermanganat-Mangan in der Zusammensetzung zu Permanganat zu oxidieren, zusetzt.

2. Verfahren nach Anspruch 1, bei dem man ein Gemisch eines anorganischen Peroxydisulfats und eines anorganischen Hypochlorits zusetzt.

3. Verfahren nach Anspruch 1, bei dem man ein Gemisch eines anorganischen Peroxydisulfats und eines anorganischen Chlorats zusetzt.

Revendications

1. Procédé pour régénérer les ions permanganate usés d'une composition de décapage alcaline contenant du permanganate, lequel procédé comprend l'addition a la composition, en une quantité suffisante pour oxyder sensiblement l'ensemble des espèces non permanganiques du manganèse de la composition en permanganate, un peroxydisulfate inorganique, facultativement mélangé avec un hypochlorite inorganique ou un chlorate inorganique.

2. Procédé suivant la revendication 1, dans lequel on ajoute un mélange d'un peroxydisulfate inorganique et d'un hypochlorite inorganique.

3. Procédé suivant la revendication 1, dans lequel on ajoute un mélange d'un peroxydisulfate inorganique et d'un chlorate inorganique.